# EUROPEAN PATENT APPLICATION

(11) **EP 0 699 918 A1**
(43) Date of publication of application: **06.03.1996**
(21) Application number: 94113728.3
(22) Date of filing: 02.09.1994
(51) Int. Cl.: G01R 31/12, H02B 13/065

(54) **A partial discharge sensing device for a gas insulated apparatus**

(71) Applicant: ABB Management AG, CH-5401 Baden (CH)
(72) Inventor: Herbst, Dr. Ingo, CH-8606 Greifensee (CH); de Kock, Nick, CH-8400 Winterthur (CH)

(57) **Abstract**

The partial discharge sensing device (p), has a resonant element and terminal means for connecting the resonant element to a measuring equipment. The resonant element is designed to resonate at a frequency band of a UHF band spectrum generated by the partial discharge and comprises a layer-shaped dielectric substrate (9) and two layer-shaped electrode arrangements applied to opposite surfaces of said dielectric substrate (9), which in particular is a printed circuit board. One of the electrode arrangements comprises a patch (10) or a ground plane (15) with a slot (16).

Such a device is preferably used in a gas-insulated apparatus, in particular in a gas insulated switchgear installation.

## Description

### BACKGROUND OF THE INVENTION

### Field of the invention

The invention relates to a partial discharge sensing device, in particular in gas-insulated equipment having one or more resonant elements which are designed to resonate at frequency bands of a ultrahigh frequency (UHF) hand spectrum generated by said partial discharge and terminal means for connecting said sensing device to a measuring equipment. The invention also relates to a partial discharge measuring system comprising such a partial discharge sensing device.

Partial discharge pulses inside gas-insulated equipment, in particular inside gas-insulated switchgear (GIS) installations, result in electromagnetic waves which propagate inside the GIS. These waves can be detected by transducers connected to electronic measuring equipment which enables one to observe the onset of dielectric problems inside the GIS. The partial discharge pulses generate resonances with frequencies which extend across the electromagnetic wave frequency spectrum well into the UHF band (300 - 3000 MHz). Partial discharge measurement in the HF and VHF (30-300 MHz) frequency bands are common techniques but experience shows that they are very susceptible to interference from external air corona which shows significant components up to a frequency in the neighbourhood of 300 MHz.

This suggests that if one wishes to avoid air corona interference one should design one's measurement system to detect the frequency components in the UHF band. However, the transducers typically used are sensitive in the VHF band. This means that one would have to use high order filters which themselves add noise and complication to the measurement system. A useful approach would be to use a transducer which, by its nature, strongly rejects unwanted frequencies.

For best sensitivity, internal installation is desired but in GIS there is a further requirement that the transducer does not intrude into the gas gap and thereby compromise the dielectric strength of the installation. This implies that an ideal transducer must have a low profile.

Another consideration is that many transducers are required because of attenuation of the partial discharge signal along the GIS. This means that each transducer should be as cheap as possible constructed.

### Discussion of background

A partial discharge sensing device of the afore-mentioned type is described in JP 32 50 712 A. The described device is used for detecting partial discharges in compressed gas insulation equipment inside a metallic container. The device comprises a metallic sheet having a plurality of slots cut out of it and having different lengths which functions as antennas with resonant frequencies defined by said slot length. Each slot is directly fed by a coaxial cable. In this manner it is possible to detect electromagnetic waves generated by partial discharges in a plurality of frequency bands.

Such a device, however, needs a solid metal arrangement which makes the device heavy and expensive. Also its incorporation into the container of the gas insulated equipment is not easy because the contact of the metal plate with the conducting surface of the container would interfere with its operation. Furthermore partial discharges in gas insulated switchgear devices may generate UHF spectra with frequency bands between 300 MHz and 1.5 GHZ. At 300 MHz the slot length would have to be 0.5 m which is nearly 60% of the inner circumference of a typical 300 kV GIS system. This makes the incorporation of the known device into the GIS system impractical.

### SUMMARY OF THE INVENTION

Accordingly an object of the invention, as defined in the patent claims, is to provide a small sized and compact partial discharge sensing device which as a part of a partial discharge measuring system can easily be incorporated into GIS installations.

The partial discharge sensing device according to the application is based on a dielectric substrate. For this reason its geometrical dimensions, in particular the size of its resonant element resp. resonant elements, can be reduced by a factor which is proportional to square root of the dielectric constant of the dielectric substrate. The use of a suitable dielectric material allows a very exact definition of the characteristic properties of the partial discharge sensing device and makes the partial discharge sensing device independent of the surface on which it is mounted.

The partial discharge sensing device is strongly resonant at one (or more) well-defined UHF band(s). At the center of each frequency band the partial discharge sensing device has a high sensitivity and rejects signals outside its bandwidth (a maximum VSWR 2:1 bandwidth of 10% of the resonant frequency is attainable). Therefore strong signals are gained and an excellent signal to noise is achieved. Also, because of the high Q-factor, absolute sensitivity is increased. Electronic noise is reduced because the need for high order filters is removed.

Furthermore the partial discharge sensing device of the invention can be manufactured very easily and cheaply by simply printing or etching electrode arrangements onto the dielectric substrate with printed circuit techniques. On account of the layer-shaped printed circuit construction the partial discharge sensing device is conformal with the shape of a GIS enclosure and can be disposed freely within this enclosure without disturbing the dielectric behaviour of the GIS essentially. Already existing GIS installations can be retrofitted with the partial discharge sensing device of the invention without any problem.

The printed circuit construction allows the feeding of the partial discharge sensing device by means of microstrip lines which are directly printed and etched onto the dielectric substrate. Such microstip lines substitute expensive coaxial cables and allow the easy integration of electronic building blocks directly onto the dielectric substrate. Such building blocks may comprise amplifiers, switches and filters.

### BRIEF DESCRIPTION OF THE DRAWING

A more complete appreciation of the invention and many of the intended advantages thereof will be readily obtained as the same becomes better understood by reference to the following detailed description when considered in connection with the accompanying drawings, wherein:
- fig.1: illustrates in a schematic manner a vertical sectional view of a portion of a gas insulated switchgear installation comprising a partial discharge mesuring device having a combination of partial discharge sensing devices according to the invention,
- fig.2: gives the amplitude response of the partial discharge sensing devices of fig.1 in function of the frequency,
- fig.3: is a top plan view and a vertical sectional view taken along the line III-III of a first embodiment of a partial discharge sensing device provided in the measuring device of fig.1,
- fig.4: is a perspective view of a second embodiment of a partial discharge sensing device provided in the measuring device of fig.1,
- fig.5: is a top perspective view and a vertical sectional view taken along the line V -V of a third embodiment of a partial discharge sensing device provided in the measuring device of fig.1,
- fig.6: is a perspective view of a fourth embodiment of a partial discharge sensing device provided in the measuring device of fig.1,
- fig.7: is a perspective view together with an enlarged view, a top plan view and a bottom plan view together with an enlarged view of a fifth embodiment of a partial discharge sensing device provided in the measuring device of fig.1 which comprises three different patch-shaped resonant elements for measuring the total or a part of the band spectrum of the partial discharge at three different centre frequencies,
- fig.8: is a perspective view together with an enlarged view, a top plan view and a bottom plan view together with an enlarged view of a sixth embodiment of a partial discharge sensing device provided in the measuring device of fig.1 which comprises four different slot-shaped resonant elements for measuring the total or a part of the band spectrum of the partial discharge at four different centre frequencies,
- fig.9: is a top and a bottom plan view of a seventh embodiment of a partial discharge sensing device according to the invention having beside patch-shaped resonant elements electronic building blocks mounted directly onto its bottom side, and
- fig.10: is a top and a bottom plan view of an eigth embodiment of a partial discharge sensing device according to the invention having beside slot-shaped resonant elements electronic building blocks mounted directly onto its bottom side.

### DESCRIPTION OF PREFFERRED EMBODIMENTS

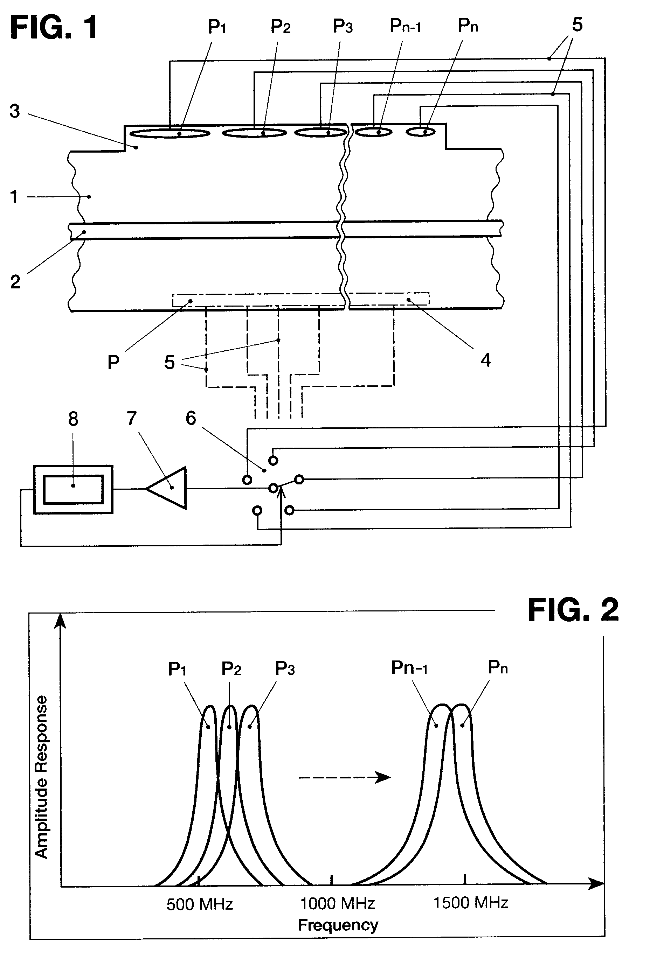

Referring now to the drawings, wherein like reference numerals designate identical or corresponding parts, in fig.1 is shown in coaxial arrangement a tubular metallic wall portion 1 and a high-voltage conductor portion 2 of a gas-insulated switchgear device. The metallic wall 1 is filled with an insulating gas under pressure, for instance with sulphur hexafluoride of up to 4 or 5 bar, and encloses partial discharge sensing devices p₁, p₂, p₃,..pₙ₋₁ and pₙ, which are disposed in a recess 3 of the wall portion 1. Each partial discharge sensing device p₁, p₂, p₂,..,pₙ₋₁ and pₙ comprises a resonant element which resonates at a centre frequency of a distinct frequency band with a band width of approximately 10% of a UHF band spectrum generated by a partial discharge occuring in the switchgear device. For a desired total bandwidth of the partial discharge extending from 300 MHz to 1500 MHz for instance 11 devices p₁, p₂, p₃,..,p₁₀ and p₁₁ with centre frequencies of 513, 567, 627, 692, 765, 846, 935, 1033, 1142, 1262 and 1395 MHz are needed.

The amplitude response of these devices and thus of a partial discharge measuring device comprising these devices can be taken from fig.2. In this case the amplitude response of the partial discharge measuring device throughout the total bandwith is comparatively high. Instead of using 11 partial discharge sensing devices it is also possible to use only 2 or 3 devices with a broader bandwidth or to limit the range of the total spectrum of the partial discharge considerably. Instead of using several partial discharge sensing devices each of which responding to a single centre frequency it is also possible to use a single partial discharge sensing device p which comprises different resonant elements for measuring the total band spectrum of the partial discharge at different centre frequencies. Within the GIS switchgear device the aforementioned partial discharge sensing device p (resp. p₁, p₂, P₃,..pₙ₋₁ or pₙ) can easily be fixed to the wall portion 1 by means of an adhesive layer 4.

Each of the partial discharge sensing devices p₁, p₂, p₃,..pₙ₋₁ and pₙ of the measuring system according to fig.1 comprises terminal means. Coaxial cables 5 are connected to the terminals means of each partial discharge sensing device p₁, p₂, p₃,..pₙ₋₁ and pₙ and are fed out of the GIS wall portion 1. Outside the cables 5 are connected to an analogue switching device 6 which via an amplifier 7 is connected to a measuring device 8.

A control mechanism integrated in the measuring device 8 acts upon the switching device 6 and selects a signal connection between a distinct partial discharge sensing device, for instance p₁, resonating with at a distinct frequency band, for instance with the centre frequency 513 MHz. The signal received from the partial discharge sensing device p₁ is fed via the switching device 6 to the amplifier 7. The amplified signal then is interpreted by the measuring device 8. In the next step the partial discharge sensing device p₂ is switched in the mesuring path and its amplitude response is measured. After having selectively switched in all the partial discharge sensing devices p₁, p₂, p₃,..,pₙ₋₁ and pₙ the measuring device can interpret all signals in the manner shown in fig.2.

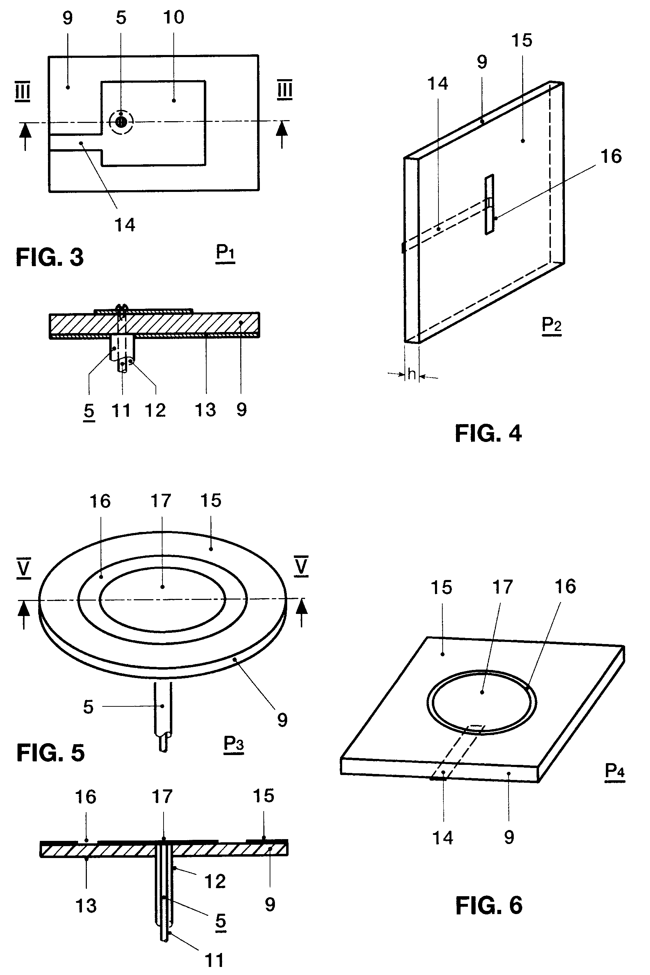

As can be taken from figures 3 - 6 in which four embodiments of the partial discharge sensing devices p₁, p₂, p₃ and p₄ of the partial discharge measuring device of fig.1 are illustrated each device comprises a layer-shaped dielectric substrate 9 and two layer-shaped electrode arrangements, preferably of a metallic material, thinly applied to opposite surfaces of the dielectric substrate 9. The dielectric constant of the dielectric substrate 9 may be 1. A typical material with such a dielectric constant may comprise a honey-comb structure, like Aeroweb (registered trade mark of Ciba Geigy UK). It is to prefer to use a material with a dielectric constant exceeding 1, preferably a material with a dielectric constant between 1 and 11, in order to reduce the wavelength corresponding to the resonant frequency of the resonant element and thus to reduce the dimensions of the partial discharge sensing device. Possible materials are polymers, like polytetrafluorethylene or cross-linked styrene copolymers, or ceramics, like quartz, alumina or mixtures of both, like ceramic-loaded PTFE.

In the embodiment of fig.3 a top electrode arrangement is formed as a rectangularly shaped patch 10. A conductor 11 of one of the coaxial cables 5 is fed through the dielectric substrate 9 and is connected by means of a small screw or by soldering to the patch 10. The screening 12 of the coaxial cable 5 is connected to an electrode arrangement which covers the bottom of the dielectric substrate 9 as a ground plane 13.

The patch 10 can be formed with any number of different shapes but the essential principle remains always the same. The patch 10 and the ground plane 13 function together as resonant element. The patch 10 radiates resp. receives at its edges. The dielectric substrate 9, the patch 10 and the ground plane 13 form a transmission line along a particular spatial dimension, which will strongly resonate at a frequency whose corresponding wavelength is twice the length of the transmission line. Hence the resonant element will radiate (and, by the reciprocity theorem, receive) significantly at the chosen centre frequency. The operating frequency of the partial discharge sensing device is chosen as a function of the physical dimensions of the patch 10 and the dielectric substrate 9 and of the value of the dielectric constant of the substrate 9.

The partial discharge sensing device of fig.3 can be manufactured very easily by printing or etching the electrode arrangements according to well-known printed circuit technologies. Instead of connecting the patch 10 with the conductor 11 of the coaxial cable 5 it is also possible to etch or to print onto the dielectric substrate 9 a strip-shaped line (microstrip) 14 which is directly connected to the patch.

The partial discharge sensing devices of fig.4 - 6 each comprise on its top side a ground plane 15 and a slot 16 which is formed into the ground plane 15. The slot 16 can have different shapes, the most preferred of which are the rectangular slot illustrated in fig.4 and the annular slot illustrated in figures 5 and 6.

The rectangular slot 16, like the patch 10, has a specific resonant dimension (in this case the length) which is at least one half of the wavelength of the resonant frequency. It also radiates from its edges and hence, by the recprocity theorem will pick up electromagnetic waves at its resonant frequency. The operational frequency is chosen by setting the slot length to at least one half of the wavelength inside the dielectric substrate 9. The thickness and/or dielectric constant of the dielectric substrate 9 and/or the width of the slot can be chosen to fine-tune the bandwidth, impedance and physical size of the slot 16. The rectangular slot can be fed either by the coaxial cable 5 or by the microstrip 14 (fig.4). Corresponding to the embodiment according to fig.3 in the case of the coaxial cable 5 its conductor 11 is led through the dielectric substrate 9 and is connected to the inner radius of the slot 16 whereas its screening 12 is connected to the ground plane 13. In the case of a microstrip 14 the microstrip is printed or etched onto the bottom of the dielectric substrate 9 and is led through the dielectric substrate 9 to an edge of the rectangular slot (fig.4).

The annular slot, like the patch 10, can also be viewed as a transmission line. In this case the resonant dimension is the inner radius of the slot 16. As above the slot width, thickness and relative permittivity of the dielectric substrate 9 can be chosen to fine-tune the bandwidth, the impedance and the physical size of the element. The annular slot 16 can be fed either by the coaxial cable 5 (fig.5) or by a microstrip 14 (fig. 6). If the slot 16 is fed by a coaxial cable 5 the conductor 11 of the coaxial cable is led through the dielectric substrate 9 to a part 17 the ground plane 15 forming the inner radius of the slot 16 (fig.5). If the slot 16 is fed by a microstrip 14 the microstrip is etched or printed onto the bottom of the dielectric substrate 9 and is led through the dielectric substrate 9 to the part 17 of the ground plane 15 forming the inner radius of the slot 16 (fig.6)

The partial discharge sensing devices of the figures 3 - 6 each comprise just one resonant element and terminal means which can be connected via the switching device 6 and the amplifier 7 to the measuring device 8. Since the active parts of these devices can be made with technologies which are well-known in the production of printing circuits these devices are extremely cheap. Furthermore they are very light and easy to handle. The devices can easily be shaped to fit the contours of the wall portion 1 of the GIS installation. Through the use of a suitable dielectric substrate 9 the devices can be made compact enough to retrofit existing GIS installations with sensing elements. The use of the dielectric material of the substrate 9 allows the exact definition of the characteristic properties of the resonant element, in particular to reduce the size of its resonant wavelength, and makes the element independent of the surface on which it is mounted.

These partial discharge sensing devices are strongly resonant at a well-defined UHF band. Therefore good VHF noise rejection is inherent. Also, because of the high Q-factor, sensitivity is increased. Electronic noise is reduced because the need for high order filters is removed. As the partial discharge sensing device is strongly resonant at a distinct UHF centre frequency it makes the development of custom-built filter electronic blocks unnecessary. Typical commercially available electronic building blocks are designed for use precisely in the UHF communication bands - for example 900 MHz mobile telephone band - and have a very small bandwidth. This means that for a conventional partial discharge sensing device one would have to develop custom-made filters at considerable expense to avoid noise interference due to communication systems.

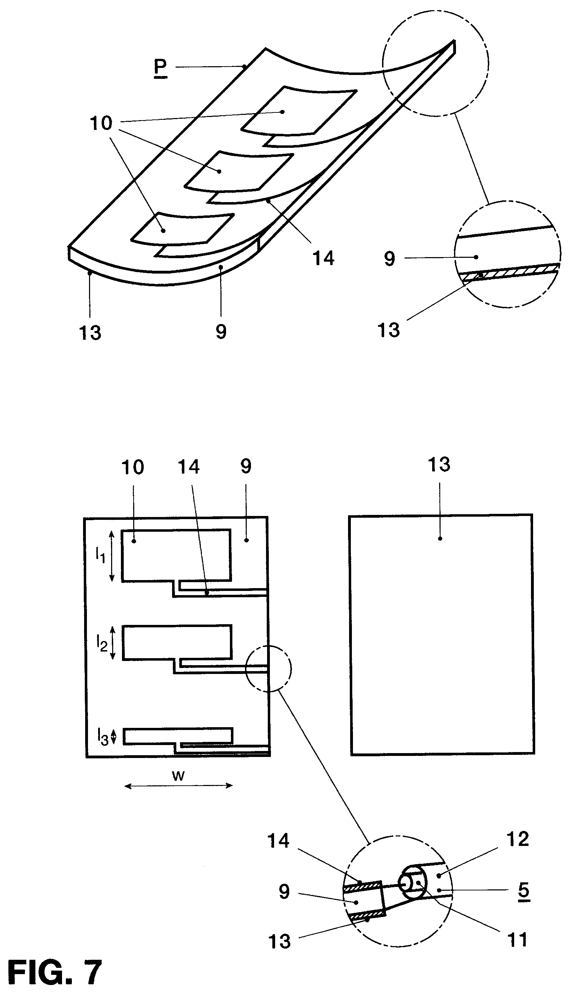

In figures 7 - 10 are illustrated four further embodiments of partial discharge sensing devices p according to the invention. Different from the embodiments according to figures 3 - 6 these partial discharge sensing devices each comprise two or more resonant elements, each of which is designed to resonate at a distinct of two or more different frequency bands of the UHF band spectrum of the partial discharge, and terminal means for connecting the resonant elements to measuring equipment.

The partial discharge sensing device p of fig.7 consists of three rectangularly shaped patches 10 disposed upon the top side of the dielectric substrate 9 and of the ground plane 13 which is disposed upon the bottom side. The patches 10 have different lengths l₁, l₂ and l₃ but the same width w. Each patch 10 is fed by means of the microstrip 14 which is disposed upon the top side of the dielectric substrate 9 between an edge of the patch 10 and an edge of the dielectric substrate 9. The feed position of the microstrip 14 with respect to the patch 10 is variable and depends on the circumstances. Each microstrip 14 then is connected to the conductor 11 of one of the coaxial cables 5. The screenings 12 of all coaxial cables 5 are connected to the ground plane 13. The signals detected by the resonant elements of this partial discharge sensing device p then can be switched, amplified and interpreted as mentioned in connection with the partial discharge measuring device of fig.1.

The partial discharge sensing device p can be disposed freely within the GIS wall portion 1. As one can take from the perspective view it is conformal with the cylindrical shape of the GIS wall portion 1. But it is also possible to make it flat in order to fit the rectangularly shaped recess 3 of the wall portion 1. The partial discharge sensing device p may also have more or less than three patch-shaped resonant elements. The patches may have nearly any shape described in connection with the partial discharge sensing device according to fig.3.

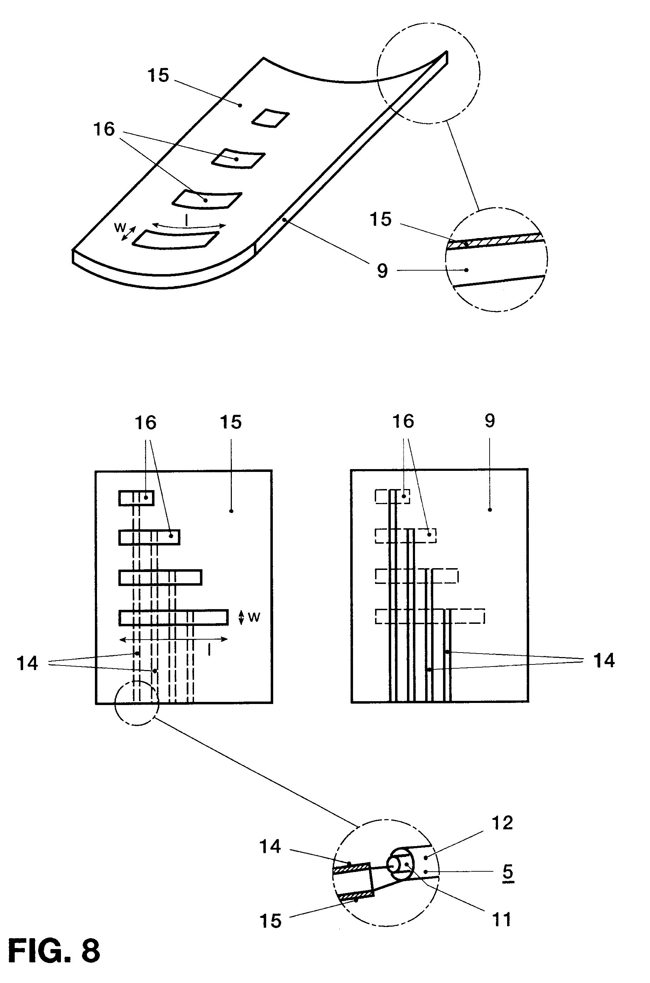

Different from the partial discharge sensing device according to fig.4 the partial discharge sensing device according to fig.8 consists of four rectangularly shaped slots 16. These slots are disposed upon the top side of the dielectric substrate 9. Microstrips 14 which are disposed upon its bottom side are led through the dielectric substrate 9. One end of each microstrip 14 is connected to an edge of a corresponding slot 16. The other end terminates at an edge of the dielectric substrate 9. The feed position of the microstrips 14 with respect to the slot 16 is variable and depends on the circumstances. Each microstrip 14 then is connected to the conductor 11 of one of the coaxial cables 5. The screenings 12 of all coaxial cables 5 are connected to the ground plane 15. The signals detected by the resonant elements of this partial discharge sensing device p then can be switched, amplified and interpreted as mentioned in connection with the partial discharge measuring device of fig.1.

Also this partial discharge sensing device can be disposed freely within the GIS wall portion 1. As one can take from the perspective view it is conformal with the cylindrical shape of the GIS wall portion 1. But it is also possible to make it flat in order to fit the rectangularly shaped recess 3 of the wall portion 1. The partial discharge sensing device may also have more or less than four slot-shaped resonant elements. The maximum length 1 of each slot 16 is set by half the wavelength of the resonant frequency in the material of the dielectric substrate 9. The slot width w can be any size up to 50% of the length 1 of the slot depending on the characteristics required.

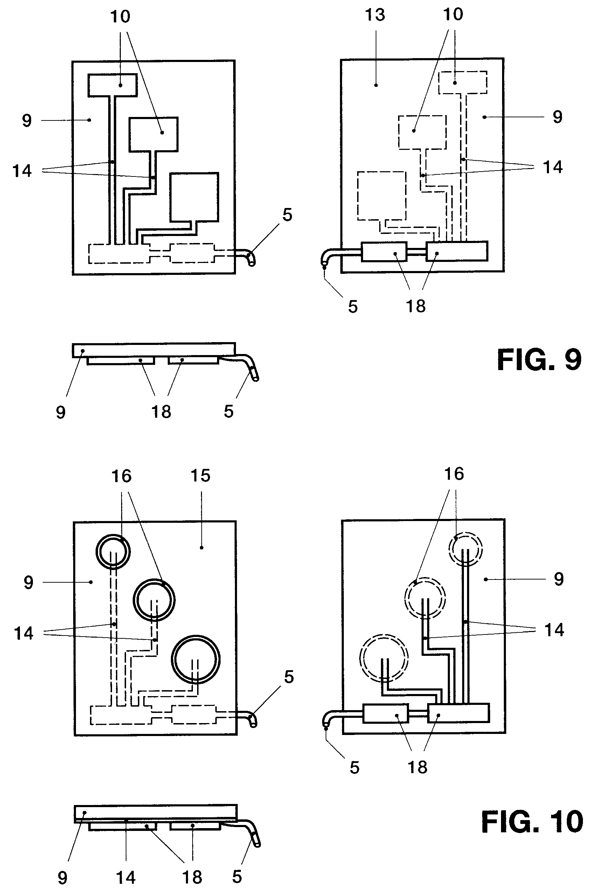

Different from the embodiment according to figures 7 and 8 the partial discharge sensing devices according to fig.9 and 10 comprise electronic building blocks 18 which are fed directly by the microstrip lines 14 and which are mounted directly onto the side of the dielectric substrate 9 carrying the microstrip lines 14. These electronic building blocks 18 comprise the switching device 6 and the amplifier 7. The resulting amplified signal is then fed out of the GIS wall portion 1 to a measuring device by the coaxial cable 5.

The advantages of the embodiments according to figures 9 and 10 are as follows:
The impedance of each resonant element comprising the patch 10 or the slot 16 and the microstrip 14 and the electronic building blocks 18 can be matched precisely. The partial discharge sensing devices thus have a great sensitivity. There are no long stretches of cables carrying weak signals which can be corrupted by external noise. The net signal comprises a greatly improved signal/noise ratio.

### List of designations

- 1: wall portion
- 2: high-voltage conductor portion
- 3: recess
- 4: adhesive layer
- 5: coaxial cables
- 6: switching device
- 7: amplifier
- 8: measuring device
- 9: dielectric substrate
- 10: patch
- 11: conductor
- 12: screening
- 13: ground plane
- 14: microstrip(s)
- 15: ground plane
- 16: slot
- 17: part of ground plane 15
- 18: electronic building blocks
p, p₁, p₂, p₃,.,pₙ₋₁, pₙ partial discharge sensing devices

## Claims

1. A partial discharge sensing device (p, p₁, p₂, p₃,..,pₙ₋₁, pₙ), in particular for use in a gas-insulated apparatus, having a first resonant element which is designed to resonate at a first frequency band of a UHF band spectrum generated by said partial discharge and first terminal means for connecting said sensing device to a measuring equipment, characterized in that said sensing device comprises a layer-shaped dielectric substrate (9) and two layer-shaped electrode arrangements applied to opposite surfaces of said dielectric substrate (9).

2. The partial discharge sensing device of claim 1, characterized in that a first of said two electrode arrangements comprises a first patch (10) or a ground plane (15) with a first slot (16) (figures 3 - 6).

3. The partial discharge sensing device of claim 1 having at least a second resonant element which is designed to resonate at a second of at least two different frequency bands of said UHF band spectrum and at least second terminal means for connecting said second resonant element to said measuring equipment, characterized in that said first resonant element comprises a first and said second resonant element a second portion of said first electrode arrangement.

4. The partial discharge sensing device of claim 3 characterized in, that said first portion is a first patch (10) or a first slot (16) formed in a ground plane (15) and that said second portion is a second patch (10) or a second slot (16) formed in said ground plane (15) (figures 7 - 10).

5. The partial discharge sensing device of any of claims 2 or 4, characterized in that said dielectric substrate and said two electrode arrangements are part of a printed circuit board.

6. The partial discharge sensing device of any of claims 2, 4 or 5, characterized in that a first terminal of said first terminal means is part of said first electrode arrangement and is connected to said first patch (10) or to a part (17) forming the inner radius of an annularly shaped first slot (16), that a second terminal of said first terminal means is a ground plane (13) of a second of said two electrode arrangements and that said first terminal is connected to the conductor (11) and said second terminal to the screening (12) of a coaxial cable (5) (figures 3, 5, 7 and 9).

7. The partial discharge sensing device of claim 6, characterized in that said conductor (11) of said coaxial cable (5) is led through said dielectric substrate (9) (figures 3 and 5).

8. The partial discharge sensing device of any of claims 2, 4 or 5, characterized in that a second of said two electrode arrangements comprises a strip-shaped line (14) which is led through said dielectric substrate (9) and which is connected to an edge of a rectangularly shaped or to a part (17) forming the inner radius of an annularly shaped first slot (16) (figures 4, 6, 8, 10).

9. The partial discharge sensing device of any of claims 6 or 8, characterized in that said first terminal is connected to an electronic building block (18) which is supported on said dielectric substrate (9) (figures 9, 10)

10. The partial discharge sensing device of any of claims 2 or 4 - 9, characterized in that said first patch (10) is shaped rectangularly, circularly or elliptically and that said first slot (16) is shaped rectangularly or annularly.

11. The partial discharge sensing device of claim 10, characterized in that the length of a rectangularly shaped first patch (10) or slot (16) is approximately one half of the wavelength corresponding to the resonant frequency of said first resonant element.

12. The partial discharge sensing device of claim 10, characterized in that the diameter of a circularly shaped first patch (10) or the inner diameter of an annularly shaped first slot (16) is approximately the wavelength corresponding to the resonant frequency of said first resonant element.

13. The partial discharge sensing device of any of claims 11 or 12, characterized in that the width of said rectangular first patch (10) or of said rectangular or annular first slot (16) and/or the thickness and/or the dielectric constant of the material of said dielectric substrate (9) are chosen to tune the bandwidth, impedance and physical size of said first patch (10) or slot (16).

14. A partial discharge measuring system with at least two partial discharge sensing devices according to claim 1 having at least a first and a second resonant element or with a partial discharge sensing device according to claim 3 and with said measuring equipment, characterized in that said measuring equipment comprises a switching device (6) for selectively connecting said at least first or second resonant element to a measuring device (8) of said measuring equipment (fig.1).

15. The partial discharge measuring system of claim 14, characterized in that said at least first or second resonant elements are connected by means of coaxial cables (5).

16. The partial discharge measuring system of claim 14, characterized in that at least said first resonant element comprises a strip-shaped line (14) which connects through said dielectric substrate (9) said first patch (10) or an edge of said first slot (16) or a part (17) forming the inner radius of an annularly shaped first slot to said switching device (6) (figures 4, 6, 8, 9 and 10).

17. The partial discharge measuring system of claim 16, characterized in that said dielectric substrate supports at least an electronic building block (18) of said measuring equipment (figures 9 and 10).

18. The partial discharge measuring system of any of claims 14 - 17 used in a gas-insulated apparatus, characterized in that at least a first (p₁) of said partial discharge sensing devices according to claim 1 or said partial discharge sensing device (p) according to claim 3 is fixed to a wall portion (1) of said gas-insulated device by means of an adhesive layer (4).

19. The partial discharge measuring system of any of claims 14 - 17 used in a gas-insulated apparatus, characterized in that at least a first (p₁) of said partial discharge sensing devices according to claim 1 or said partial discharge sensing device (p) according to claim 3 is disposed in a recess (3) of wall portion (1) of said gas insulated apparatus and is of flat design.
